(19) Europäisches Patentamt
European Patent Office
Office européen des brevets

(11) **EP 2 259 419 A1**

(12) **EUROPEAN PATENT APPLICATION**
published in accordance with Art. 153(4) EPC

(43) Date of publication:
**08.12.2010 Bulletin 2010/49**

(51) Int Cl.:
*H02M 7/48* (2007.01)

(21) Application number: **09720739.3**

(22) Date of filing: **10.03.2009**

(86) International application number:
**PCT/JP2009/001068**

(87) International publication number:
**WO 2009/113298 (17.09.2009 Gazette 2009/38)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **11.03.2008 JP 2008061163**

(71) Applicant: **Daikin Industries, Ltd.**
**Osaka-shi, Osaka 530-8323 (JP)**

(72) Inventors:
• **HIBINO, Hiroshi**
  **Kusatsu-shi**
  **Shiga 525-8526 (JP)**
• **SEKIMOTO, Morimitsu**
  **Kusatsu-shi**
  **Shiga 525-8526 (JP)**

(74) Representative: **HOFFMANN EITLE**
**Patent- und Rechtsanwälte**
**Arabellastraße 4**
**81925 München (DE)**

(54) **POWER CONVERSION DEVICE**

(57) In a power converter for converting AC power supplied from an AC power source or DC power supplied from a DC power source to DC power or AC power having predetermined voltage and frequency including at least one switching device (130) configured to be operable at high temperature, at least one snubber circuit (300) configured to be operable at high temperature and having a capacitor (301) configured to be operable at high temperature is provided.

FIG. 1

## Description

### TECHNICAL FIELD

The present invention relates to a power converter including a switching device.

### BACKGROUND ART

Conventionally, as a power converter such as an inverter for converting a DC voltage to an AC voltage and a converter for converting an AC voltage to a DC voltage, apparatuses which performs power conversion using a plurality of switching devices have been known. Also, there are examples where such a switching device of an inverter is comprised of a SiC semiconductor device (see, for example, Patent Document 1).

Wide band gap semiconductor such as the above-described SiC semiconductor has a high dielectric breakdown field, compared to known Si semiconductor (i.e., semiconductor using Si crystal) (for example, the dielectric breakdown field of SiC semiconductor is about 10 times as high as that of Si semiconductor), and thus, the breakdown voltage of devices using such wide band gap semiconductor can be increased in a simple manner. Also, to realize the same breakdown voltage, a device using wide band gap semiconductor can be formed to have a smaller thickness than that of a device using Si semiconductor. Accordingly, a device with a small size and small conduction loss can be achieved.

Since the above-described wide band gap semiconductor allows high speed operation and operation at high temperature (for example, at 200 °C), the efficiency of an entire apparatus can be increased by high speed operation. Also, a cooling structure can be simplified because an operation at high temperature is possible. Thus, the size of the apparatus can be reduced.

In such a power converter, in addition to the above-described semiconductor, a device such as a capacitor is employed. For example, if a surge voltage is generated by an inductance of an interconnect when a switching device is turned on/off, the switching device might be broken. Thus, a snubber circuit is used as a protection circuit so as to reduce the surge voltage. In many cases, a snubber circuit including a capacitor is used.

### CITATION LIST

### PATENT DOCUMENT

PATENT DOCUMENT 1: Japanese Patent Publication No. 2000-224867

## SUMMARY OF THE INVENTION

### TECHNICAL PROBLEM

As described above, the above-described wide band gap semiconductor allows high speed operation and operation at high temperature (for example, at 200 °C), and thus, when being used in a power converter, the power converter can be operated with high efficiency and also at high temperature due to the high speed operation.

To achieve high speed operation, the above-described snubber circuit has to be arranged as close as possible to a switching device. This is because to perform switching by a switching device (hereinafter also referred to as a "SiC switching device") using wide band gap semiconductor at higher speed than that of a known Si semiconductor switching device and to keep the surge voltage at the same level as that of the known switching device, the inductance of the interconnect has to be reduced. Specifically, the snubber circuit has to be arranged at a closer distance to the switching device than a distance between a switching device and a snubber circuit in a known power converter including a Si semiconductor switching device.

However, the upper limit of an allowable temperature of a capacitor in general is about 150 °C, which is lower than an operating temperature of the SiC switching device. Therefore, there might be cases where, if a snubber circuit including a capacitor is arranged close to a SiC switching device, heat is generated by the SiC switching device, and thus, the operating temperature of the snubber circuit exceeds the allowable temperature of the snubber circuit. Accordingly, it can be also considered to use the switching device in a temperature range which does not go over the allowable temperature of the snubber circuit. However, to do so, the capacity of the device has to be increased to reduce the amount of generated heat, or like measure has to be taken. Also, when the switching device is used at reduced switching speed to reduce the surge voltage, the switching loss is increased, and as a result, the size of a cooling structure is increased, thus resulting in increase in cost. That is, to realize high speed operation, the snubber circuit and the switching device have to be arranged so close to one another that heat insulation cannot be provided between the snubber circuit and the switching device.

In view of the above-described problems, the present invention has been devised, and it is therefore an object to allow a snubber circuit to be arranged close to a switching device having a higher operating temperature than that of a Si semiconductor switching device.

### SOLUTION TO THE PROBLEM

To solve the above-described problems, a first aspect of the present invention is directed to a power converter for converting AC power supplied from an AC power source or DC power supplied from a DC power source to DC power or AC power having predetermined voltage and frequency, and the power converter includes: at least one switching device (130) configured to be operable at high temperature; and at least one snubber circuit (300) configured to be operable at high temperature and having a capacitor (301) configured to be operable at high temperature.

Thus, the snubber circuit (300) can be operated at high temperature (for example, at a temperature equal to or higher than an operating temperature of the switching device (130)).

According to a second aspect of the present invention, in the power converter of the first aspect, an operating temperature of the at least one switching device (130) is 150°C or more.

Thus, the switching device (130) is operated at 150°C or more.

According to a third aspect of the present invention, in the power converter of the first or second aspect of the present invention, the at least one switching device (130) is a semiconductor device using wide band gap semiconductor as a primary material.

Thus, the switching device (130) comprised of the wide band gap semiconductor performs a switching operation.

According to a fourth aspect of the present invention, in the power converter of any one of the first to third aspects of the present invention, an allowable temperature of the at least one snubber circuit (300) is 150°C or more.

Thus, the snubber circuit (300) can be performed in an atmosphere at 150°C or more.

According to a fifth aspect of the present invention, in the power converter of the fourth aspect of the present invention, the capacitor (301) of the at least one snubber circuit (300) is a ceramic capacitor.

Thus, in the snubber circuit (300), the ceramic capacitor reduces the surge voltage.

According to a sixth aspect of the present invention, in the power converter of the fourth aspect of the present invention, the capacitor (301) of the at least one snubber circuit (300) is a film capacitor using a high heat resistance material as a dielectric material.

Thus, in the snubber circuit (300), the film capacitor reduces the surge voltage.

According to a seventh aspect of the present invention, in the power converter of any one of the first through sixth aspects of the present invention, the at least one snubber circuit (300) includes a diode using wide band gap semiconductor as a primary material.

According to an eighth aspect of the present invention, in the power converter of the third or seventh aspect of the present invention, the wide band gap semiconductor is one of silicon carbide, gallium nitride and diamond.

Thus, the switching device (130) or the diode of the snubber circuit (300) is comprised of the wide band gap semiconductor to perform a switching operation or reduce the surge voltage.

According to a ninth aspect of the present invention, in the power converter of any one of the first through eighth aspects of the present invention, multiple ones of the at least one switching device (130) are connected in series to serve as a series circuit (170), multiple ones of the series circuit (170) are arranged in parallel, and multiple ones of the at least one snubber circuit (300) are arranged so that each of the snubber circuits (300) corresponds to an associated one of the series circuits (170).

According to a tenth aspect of the present invention, in the power converter of any one of the first through ninth aspects of the present invention, the at least one snubber circuit (300) is arranged so that each of the at least one snubber circuit (300) corresponds to an associated one of the at least one switching device (130).

According to an eleventh aspect of the present invention, in the power converter of any one of the first through tenth aspects of the present invention, the at least one switching device (130) and the at least one snubber circuit (300) are arranged in the same package.

According to a twelfth aspect of the present invention, in the power converter of any one of the first through eleventh aspects of the present invention, the at least one switching device (130) and the at least one snubber circuit (300) are arranged on the same substrate.

Thus, the switching device (130) and the snubber circuit (300) are arranged close to one another.

According to a thirteenth aspect of the present invention, in the power converter of the eleventh or twelfth aspect of the present invention, the at least one switching device (130) is directly connected to terminals of the at least one snubber circuit (300).

According to a fourteenth aspect of the present invention, in the power converter of any one of the eleventh through thirteenth aspects of the present invention, each of all of terminals of the at least one snubber circuit (300) electrically coupled to the at least one switching device (130) is directly connected to the at least one switching device (130), an interconnect member directly connected to the at least one switching device (130), or an interconnect member directly connected to the at least one switching device (130) via a heat spreader (510).

Thus, the switching device (130) and the terminals of the snubber circuit (300) connected to the switching device (130) are arranged close to one another.

According to a fifteenth aspect of the present invention, in the power converter of any one of the first through fourteenth aspects of the present invention, the power converter drives a drive motor (40) provided in a compressor (20) including a compression mechanism (50) for compressing a refrigerant, the drive motor (40) for driving the compression mechanism (50) and a casing (30) in which the compression mechanism (50) and the drive motor (40) are provided and which is filled with the refrigerant.

Thus, in the power converter for driving the drive motor (40), the snubber circuit (300) can be performed at high temperature (for example, at a temperature equal to or higher than the operating temperature of the switching device (130)).

According to a sixteenth aspect of the present invention, in the power converter of the fifteenth aspect of the present invention, the compression mechanism (50) is configured to discharge a high-pressure refrigerant into the casing (30), and a discharge pipe (35) for causing the high-pressure refrigerant in the casing (30) to flow to the outside of the casing (30) is connected to the casing (30).

Thus, the casing (30) is filled with the high-pressure refrigerant.

According to a seventeenth aspect of the present invention, in the power converter of the fifteenth or sixteenth aspects of the present invention, the at least one snubber circuit (300) and the at least one switching device (130) are arranged in the casing (30).

According to an eighteenth aspect of the present invention, in the power converter of any one of the fifteenth through seventeenth aspects of the present invention, the drive motor (40) includes a stator core portion (42a) fixed to an inner wall of the casing (30) and insulating portions (42c) formed on end surfaces of the stator core portion (42a) in a direction along a shaft, and the at least one switching device (130) and the at least one snubber circuit (300) are supported by the insulating portions (42c).

According to a nineteenth aspect of the present invention, in the power converter of any one of the fifteenth through eighteenth aspects of the present invention, the at least one switching device (130) and the at least one snubber circuit (300) are arranged between the compression mechanism (50) and the discharge pipe (35).

According to a twentieth aspect of the present invention, in the power converter of any one of the fifteenth through nineteenth aspects of the present invention, the compressor (20) is connected to a heat pump circuit including a refrigerant circuit (10) for performing refrigeration cycle by a refrigerant circulating.

Thus, the high-pressure refrigerant in the casing (30) cools down the snubber circuit (300) of the power converter for driving the drive motor, and the switching device (130).

A twenty first aspect of the present invention is directed to a power converter for converting AC power supplied from an AC power source or DC power supplied from a DC power source to DC power or AC power having predetermined voltage and frequency, and the power converter includes: at least one switching device (130); and at least one snubber circuit (300) including a capacitor (301), and each of all of terminals of the at least one snubber circuit (300) electrically coupled to the at least one switching device (130) is directly connected to the at least one switching device (130), an interconnect member directly connected to the at least one switching device (130), or an interconnect member directly connected to the at least one switching device (130) via a heat spreader (510).

Thus, the switching device (130) and the terminals of the switching devices (130) connected to the switching device (130) are arranged close to one another.

ADVANTAGES OF THE INVENTION

According to the first aspect of the present invention, the snubber circuit (300) can be operated at high temperature (for example, at a high temperature equal to or higher than an operating temperature of the switching device (130)), and thus, the snubber circuit (300) can be arranged close to the switching device (130). Therefore, the interconnect inductance can be reduced and like advantages can be achieved, and thus, high speed operation of the power converter can be realized.

According to the second aspect of the present invention, the allowable temperature of the switching device (130) is 150°C or more, and thus, the power converter can be performed at 150°C or more.

According to the third aspect of the present invention, high speed switching can be performed by the switching device (130) at high temperature.

According to the fourth aspect of the present invention, the snubber circuit (300) is operated at 150°C or more, and thus, the snubber circuit (300) can be used for the power converter operable in an atmosphere at 150°C or more.

According to the fifth or sixth aspect of the present invention, power conversion can be performed at a temperature equal to or higher than a predetermined temperature (for example, at 150°C or more).

According to the seventh or eighth aspect of the present invention, the switching device (130) or the diode of the snubber circuit (300) is comprised of wide band gap semiconductor, and thus, in the power converter, efficient power conversion can be performed at a temperature equal to or higher than a predetermined temperature (for example, at 150°C or more).

According to the ninth through fourteenth aspects of the present invention, the switching device (130) and the snubber circuit (300) are arranged close to one another, and thus, the interconnect inductance between the switching device (130) and the snubber circuit (300) can be reduced.

According to the fifteenth or sixteenth aspect of the present invention, in the power converter for driving the drive motor (40), high speed operation of the power converter can be realized, and thus, the operation efficiency of the compressor can be improved.

According to the seventeenth through twentieth aspects of the present invention, the switching device (130) and the snubber circuit (300) are arranged close to one anther. Therefore, the interconnect inductance can be reduced and like advantages can be achieved, and thus, high speed operation of the power converter can be realized. Furthermore, the high-pressure refrigerant in the casing (30) cools down the snubber circuit (300) and the switching device (130) of the power converter for driving the drive motor (40), and thus, the power converter (i.e., an air conditioner) can be more efficiently operated.

According to the twenty first aspect of the present invention, the switching device (130) and the snubber circuit (300) are arranged close to one another, and thus, the interconnect inductance between the switching device (130) and the snubber circuit (300) can be reduced.

BRIEF DESCRIPTION OF THE DRAWINGS

[FIG. 1] FIG. 1 is a diagram illustrating a configuration of a power converter according to a first embodiment.
[FIG. 2] FIG. 2 is a diagram illustrating the concept of interconnect length.
[FIG. 3] FIGS. 3A-3F are diagrams showing other configuration examples of a snubber circuit.
[FIG. 4] FIG. 4 is a diagram illustrating a configuration of a power converter where a snubber circuit is provided for each switching device (130).
[FIG. 5] FIG. 5 is a diagram illustrating a piping system of a refrigerant circuit in a heat pump apparatus according to a second embodiment.
[FIG. 6] FIG. 6 is a longitudinal sectional view illustrating a schematic configuration of a fluid machine according to the second embodiment.
[FIG. 7] FIG. 7A is a diagram of a circuit where a snubber circuit is provided for each series circuit. FIG. 7B is a view describing an example arrangement of switching devices and snubber circuits provided on a chip.
[FIG. 8] FIGS. 8A and 8B are views showing examples of vertical MOSFET structures. FIG. 8A shows a DiMOSFET. FIG. 8B shows a UMOSFET.
[FIG. 9] FIG. 9 is a view describing another example arrangement of switching devices and snubber circuits provided on a chip where a snubber circuit is provided for each series circuit.
[FIG. 10] FIG. 10 is a view describing still another example arrangement of switching devices and snubber circuits provided on a chip where a snubber circuit is provided for each series circuit.
[FIG. 11] FIG. 11A is a diagram of a circuit where a snubber circuit is provided for each switching device. FIG. 11B is a view describing another example arrangement of switching devices and snubber circuits provided on a chip.
[FIG. 12] FIG. 12 is a view describing another example arrangement of switching devices and snubber circuits provided on a chip where a snubber circuit is provided for each switching device.

[FIG. 13] FIG. 13A is a diagram of an example circuit where a snubber circuit is provided for each switching device. FIG. 13B is a view describing an example arrangement of switching devices and snubber circuits provided on a chip.
[FIG. 14] FIG. 14 is a view describing another example arrangement of switching devices and snubber circuits provided on a chip where a snubber circuit is provided for each switching device.
[FIG. 15] FIG. 15 is a view describing still another example arrangement of switching devices and snubber circuits provided on a chip where a snubber circuit is provided for each switching device.

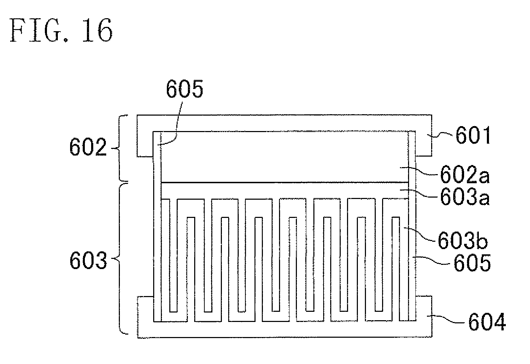

[FIG. 16] FIG. 16 is a view describing an example of a chip configuration for a snubber circuit.

DESCRIPTION OF REFERENCE CHARACTERS

| | |
|---|---|
| 1 | Air conditioner |
| 10 | Refrigerant Circuit |
| 20 | Compressor |
| 30 | Casing |
| 35 | Discharge Pipe |
| 40 | Drive Motor |
| 42a | Stator Core Portion |
| 42c | Insulator (Insulating Portion) |
| 50 | Compression Mechanism |
| 100 | Power Converter |
| 130 | Switching Device |
| 170 | Series Circuit |
| 300 | Snubber Circuit |
| 301 | Capacitor |
| 510 | Heat Spreader |
| 520 | Bonding Wire |

DESCRIPTION OF EMBODIMENTS

Hereinafter, embodiments of the present invention will be described with reference to the accompanying drawings. Note that the following embodiments are set forth merely for purposes of preferred examples in nature, and are not intended to limit the scope, applications, and use of the invention. In the following description of each embodiment and variation, each component having substantially the same function as an already described function is identified by the same reference numeral, and therefore, the description thereof will be omitted.

«First Embodiment»

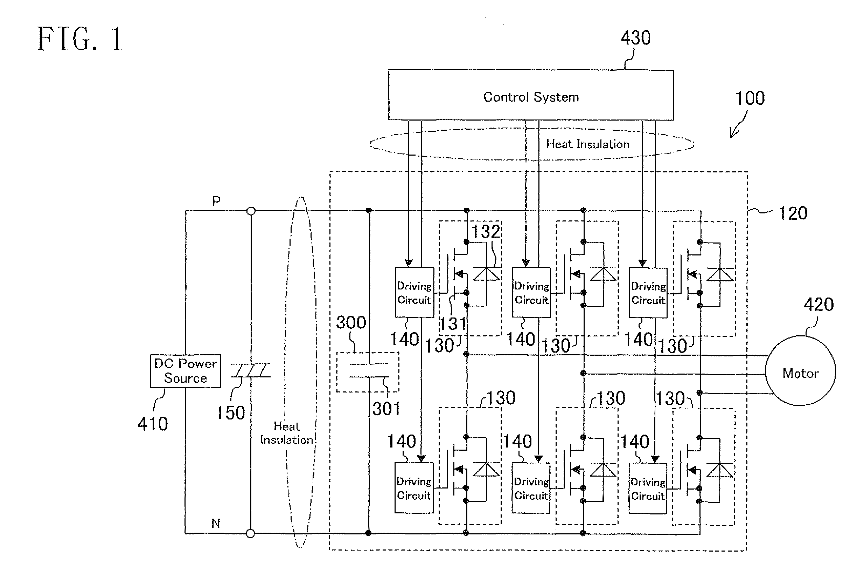

A configuration of a power converter according to a first embodiment of the present invention is shown in FIG. 1. The power converter (100) includes a smoothing capacitor (150) and an inverter circuit (120), and the inverter circuit (120) controlled by a control system (430) converts a DC input from a DC power source (410) to a three-phase AC to supply the obtained three-phase AC to a three-phase AC motor (420). The three-phase AC motor (420) drives a compressor provided to a refrigerant circuit of an air conditioner. Note that the DC power source (410) can be comprised of a converter circuit for rectifying an AC power source such as, for example, a commercial AC power source and the like.

The smoothing capacitor (150) is a capacitor for smoothing a voltage of the AC power source. For example, an electrolytic capacitor can be used as the smoothing capacitor (150). An upper limit of an allowable temperature of the electrolytic capacitor is about 100 °C, and thus, in this embodiment, the smoothing capacitor (150) is thermally insulated from the inverter circuit (120).

The inverter circuit (120) includes a switching device (130), a driving circuit (140), and a snubber circuit (300). These components are comprised of only devices operable at 150°C or more.

Specifically, in this case, six switching devices (130) are provided in the inverter circuit (120), each of the switching devices (130) is comprised of a switching device (including a SiC MOSFET and a SiC diode in this case) using wide band gap semiconductor. In addition to SiC (silicon carbide), gallium nitride (GaN), diamond and the like can be used as wide band gap semiconductor. Note that the maximum operating temperature of a known Si semiconductor device is 150°C, and the maximum operating temperature of a wide band gap semiconductor device is higher than that of a Si semiconductor device. In general, the maximum operating temperature of wide band gap semiconductor is 150°C or more. Accordingly, as in this embodiment, the maximum operating temperature of the switching device (130) using wide band gap semiconductor is 150°C or more.

Specifically, each of the switching devices (130) includes a transistor (131) and a freewheeling diode (132).

The driving circuits (140) are provided so that each of the driving circuits (140) corresponds to an associated one of the switching devices (130). That is, six driving circuits (140) are provided in the inverter circuit (120). In response to control by the control system (430), each of the driving circuits (140) controls a gate potential of the transistor (131) in the corresponding switching device (130) to switch the transistor (131) on/off.

The snubber circuit (300) is a circuit for reducing a surge voltage generated in the inverter circuit (120) and, according to this embodiment, is comprised of a capacitor (301). The snubber circuit (300) is electrically coupled between two input terminals of the inverter circuit (120). The snubber circuit (300) and the inverter circuit (120) are arranged close to one another. Specifically, the snubber circuit (300) and the inverter circuit (120) have to be arranged so that a distance therebetween is smaller than a distance between an inverter circuit (120) and a snubber circuit (300) in a known power converter using a Si semiconductor device. In such an arrangement, in general, the snubber circuit (300) and the inverter circuit (120) are arranged so close to one another that heat insulation cannot be provided therebetween.

As an example of inverter circuits using Si semiconductor, there is an inverter circuit in which the interconnect inductance is 10 nH or less (including a shunt resistance for current detection) and the switching speed is 200 ns. Based on this example, the arrangement according to this embodiment will be discussed.

Presumably, in a switching device comprised of SiC semiconductor, switching can be performed at ten times the speed of a switching device using Si or at higher speed. To realize a switching device (130) comprised of SiC semiconductor, thereby performing high speed switching, and furthermore, keeping a surge voltage generated due to an interconnect inductance at the same level as that in a known device, the interconnect inductance has to be reduced. For example, to realize switching speed equal to ten times the switching speed which has been currently realized, the interconnect inductance has to be 1 nH or less.

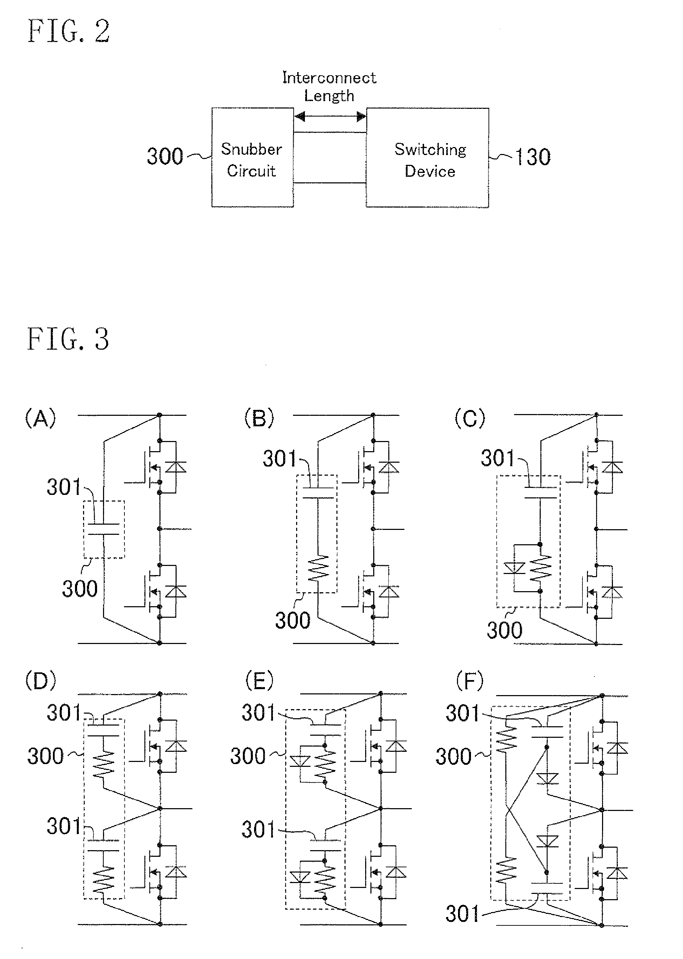

The relationship between an interconnect length (i.e., as shown in FIG. 2, the distance between a snubber circuit and a corresponding switching device), an interconnect diameter and an interconnect inductance can be expressed by the following equation.

[Equation 1]

$$L = 2l\left[\ln\left(\frac{4l}{d}\right) - \frac{3}{4}\right] \text{[nH]}$$
$$l \ : \text{Length [cm]}$$
$$d \ : \text{Diameter [cm]}$$

Base on this equation, the interconnect length (the distance between the snubber circuit and the switching device) and the interconnect diameter to cause the interconnect induction to be 1 nH or less is calculated. Then, the calculation result shows that the snubber circuit is preferably arranged at a distance of 2 mm or less when the interconnect has a diameter of 2 mm.

Also, it is understood from this equation that, if a power converter is configured so that the snubber circuit is thermally insulated from the switching device, the diameter of the interconnect becomes too large. For example, assuming that a necessary distance for thermally insulating the snubber circuit from the switching circuit is about 5 mm, the interconnect length (i.e., the distance between the snubber circuit and the switching circuit) is 5 mm or more. When the interconnect length is 5 mm and the interconnect diameter is 2 mm, the interconnect inductance is 4.5 nH based on the above-described equation. To obtain 1 nH or less for the interconnect inductance when the interconnect length is 5 mm, the diameter has to be 10 mm or more. As the diameter of the interconnect increases, the heat resistance of the interconnect decreases but the amount of heat transferred from the interconnect increases, so that heat insulation cannot be provided.

For example, according to the following equation, if an allowable voltage range for a surge voltage generated when switching of a current of 10 A is performed at switching speed of 1 ns is up to 100 V, the inductance has to be 10 nH or less.

[Equation 2]

$$v_L = L \cdot di/dt$$

In this case, the interconnect inductance of the interconnect with an interconnect length of 9 mm and a diameter of 2 mm is 10.2 nH, and the switching device and the snubber circuit have to be arranged with a distance of 9 mm or less therebetween. In an actual situation, inductances of a bonding wire and the snubber circuit affect the surge voltage, and therefore, the switching device and the snubber circuit have to be arranged even closer.

As described above, when the snubber circuit (300) and the switching devices (130) are arranged close to one another, the operating temperature of the capacitor (301) is substantially equal to the operating temperature of the switching devices (130). Therefore, in this embodiment, a capacitor whose operating temperature is substantially equal to or higher than the operating temperature of the switching devices (130) is employed as the capacitor (301). Considering the operating temperature of the switching devices (130) comprised of SiC semiconductor when being operated at high speed as described above, the allowable temperature of the capacitor (301) is preferably, for example, 150°C or more.

As a capacitor which is operable at high temperature in the above-described manner, for example, a ceramic capacitor or a film capacitor in which a high heat resistance material is used as a dielectric material can be used. Note that examples of high heat resistance materials are: polyamide (PA), polyamide imide (PAI), polyacrylate (PAR), polyamide (PI), polyetherimide (PET), polyether ether ketone (PEEK), polyether sulfone (PES), polysulfone (PSF), polyphenylene sulfide (PPS), polybenzimidazole (PBI), liquid crystal polymer (LCP) and the like.

As described above, the control system (430) controls on and off of each of the switching devices (130) via an associated one of the driving circuits (140). The control system (430) is arranged so as to be insulated form the power converter (100).

In the above-described power converter (100), the capacitor (301) in the snubber circuit (300) is configured to be operable at high temperature (i.e., in the above-described example, the allowable temperature is higher than the operating temperature of the switching devices (130)), so that the snubber circuit (300) can be arranged close to the switching devices (130) which are SiC switching devices (whose operating temperature is higher than that of a Si semiconductor switching device). Accordingly, the interconnect inductance can be reduced and like advantages are achieved, and thus, high operation of the inverter circuit (120) (i.e., high speed operation of the electric power converter (100)) can be realized.

«Variations of First Embodiment (Variations of Snubber Circuit)>>

In addition to the above-described circuit comprised of only the capacitor (301), for example, circuits having configurations of FIGS. 3B-3F can be employed as the snubber circuit (300). In FIG. 3A, the above-described circuit comprised of only the capacitor (301) is shown again. In some of these examples, a resistor, a diode and the like are provided in addition to the capacitor. Each of those components is configured to be operable at high temperature (for example, at a temperature equal to or higher than the operating temperature of the switching devices (130)).

«Second Embodiment>>

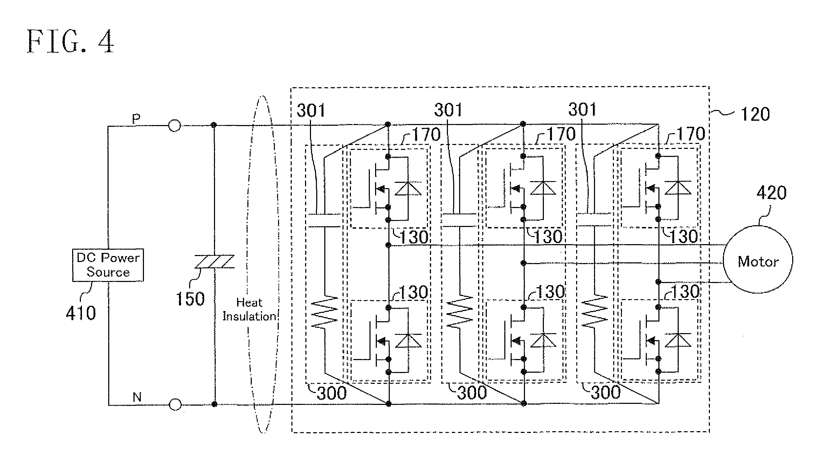

FIG. 4 shows an example in which a snubber circuit is provided for each switching device (130). In this example, the snubber circuit shown in FIG. 3B is used as the snubber circuit. Note that in FIG. 3B, a driving circuit and the like are not shown. In an inverter circuit (120), components are comprised of only devices operable at 150°C or more.

The term "phase" herein means a part at which the switching devices (130) are connected in series (i.e., a series circuit (170) in FIG. 4). As in the case where high speed switching is performed, if the impedance of an interconnect between phases is a problem, this arrangement for the snubber circuit is effective.

«Third Embodiment»

In a third embodiment of the present invention, an example in which a power converter is used as a heat pump apparatus will be described.

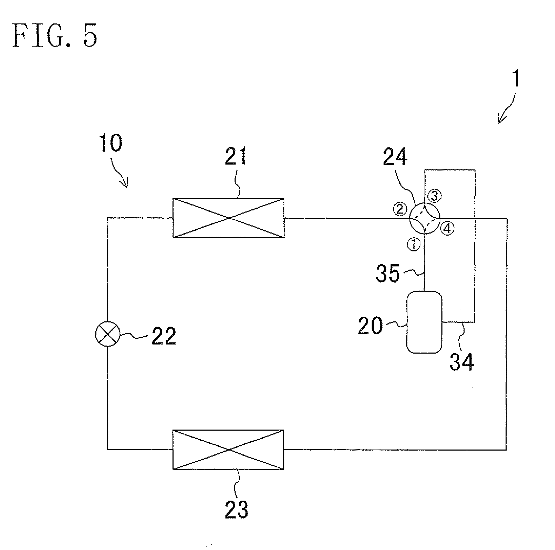

A heat pump apparatus according to the third embodiment of the present invention serves as an air conditioner (1) for switching between a cooling operation and a heating operation to cool and heat a room interior. As shown in FIG. 5, the air conditioner (1) includes a refrigerant circuit (10). The refrigerant circuit (10) is filled with a chlorofluorocarbon refrigerant as a refrigerant. In the refrigerant circuit (10), a refrigerant circulates, and thereby, a vapor compression refrigeration cycle is performed.

<Configuration of Refrigerant Circuit>

A compressor (20), an indoor heat exchanger (21), an expansion valve (22), an outdoor heat exchanger (23) and a four way valve (24) are connected to the refrigerant circuit (10). The compressor (20) used in the third embodiment is a rotary compressor, which serves as a fluid machine according to the present invention. The compressor (20) will be described in detail later. The indoor heat exchanger (21) is placed in a room. In the indoor heat exchanger (21), heat is exchanged between a refrigerant and room air. The outdoor heat exchanger (23) is arranged outside the room. In the outdoor heat exchanger (23), heat is exchanged between a refrigerant and outside air. The expansion valve (22) is a decompression means for decompressing the refrigerant, and is comprised of, for example, an electronic expansion valve. The four-way switching valve (24) includes four ports, i.e., first through fourth ports. In the four-way switching valve (24), the first port is connected to a discharge side of the compressor (20), the second port is connected to the indoor heat exchanger (21), the third port is connected to an inlet side of the compressor (20), and the fourth port is connected to the outdoor heat exchanger (23). The four-way switching valve (24) is configured to switch between a state where the first port and the second port are connected together and the third port and the fourth port are connected together (as indicated by a solid line in FIG. 5) and a state where the first port and the fourth port are connected together and the second port and the third port are connected together (as indicated by a dashed line in FIG. 5).

<Confguration of Compressar>

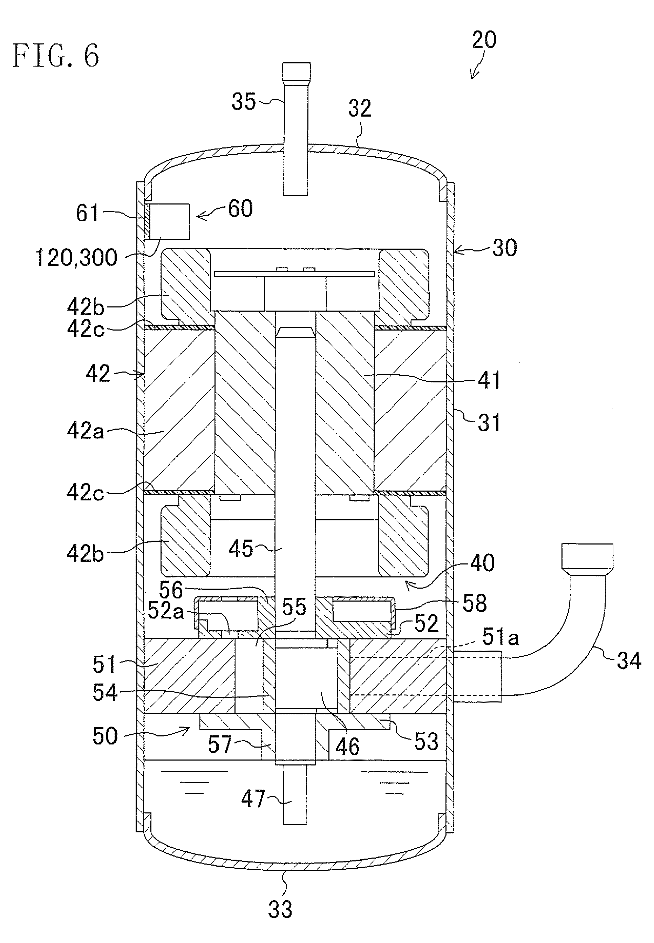

As shown in FIG. 6, the compressor (20) includes a hollow, sealed casing (30). The casing (30) includes a cylindrical body portion (31), a top plate portion (32) provided at an upper end part of the body portion (31), and a bottom plate portion (33) provided at a lower end part of the body portion (31). In the casing (30), an inlet pipe (34) is connected to a lower part of the body portion (31), and a discharge pipe (35) is connected to the top plate portion (32). The discharge pipe (35) vertically passes through the top plate portion (32), and a lower end of the discharge pipe (35) opens in an interior space. Note that the casing (30) is made of a metal material such as, for example, iron and the like.
A drive motor (40), a drive shaft (45) and a compression mechanism (50) are provided in the casing (30).
The drive motor (40) is arranged in an upper space in the casing (30). The drive motor (40) includes a rotor (41) and a stator (42). The rotor (41) is fixed so as to be located around the drive shaft (45). The stator (42) is provided at the outer periphery of the rotor (41). The stator (42) includes a stator core portion (42a) to be fixed to an inner wall of the body portion (31) of the casing (30) and coil portions (42b) provided above and below the stator core portion (42a). Insulators (42c) are provided at upper and lower end surfaces of the stator core portion (42a) in the direction along the shaft. The insulators (42c) are made of an insulating material and serve as insulation portions for providing insulation between the stator core portion (42a) and each of the coil portions (42b).
The drive shaft (45) is formed so as to vertically extend along the shaft center of the casing (30). In the drive shaft (45), an eccentric portion (46) is formed at a lower part thereof. The eccentric portion (46) has a larger diameter than that of the drive shaft (45), and is decentered from the shaft center of the drive shaft (45) by a predetermined distance. Also, in the drive shaft (45), an oil pump (47) is provided at a lower end portion thereof. The oil pump (47) is configured to pump up oil accumulated in a bottom portion of the casing (30) by centrifugal force. Oil pumped up by the oil pump (47) is supplied to each slide member such as an inside of the compression mechanism (50), a bearing of the drive shaft (45) and the like through an oil supply path (not shown) formed in the drive shaft (45).
The compression mechanism (50) is arranged in a lower space in the casing (30). The compression mechanism (50) includes a cylinder (51), a front head (52), a rear head (53), and a piston (54).
The cylinder (51) is formed to have a round cylindrical shape, and an outer periphery of the cylinder (51) is fixed to the inner wall of the casing (30). On the inside of the cylinder (51), a cylinder chamber (55), which is a cylindrical hollow, is formed. An inlet path (51a) is formed so as to extend in the direction along the diameter in the cylinder (51). The inlet path (51a) communicates the cylinder chamber (55) with the inlet pipe (34).
The front head (52) is attached to an upper side of the cylinder (51), and the rear head (53) is attached to a lower side of the cylinder (51). The front head (52) blocks an upper end opening portion of the cylinder chamber (55), and the rear head (53) blocks a lower end opening portion of the cylinder chamber (55). Furthermore, an upper bearing (56) is provided to the front head (52), and a lower bearing (57) is provided to the rear head (53). The drive shaft (45) passes through the front head (52) and the rear head (53) and is pivotally supported by the upper bearing (56) and the lower bearing (57).
In the front head (52), a discharge port (52a) for communicating the cylinder chamber (55) with the interior space of the casing (30) is provided. A discharge valve, which is not shown, is provided to the discharge port (52a). Furthermore, a silencing muffler (58) is attached to the front head (52) so as to cover the discharge port (52a).
The piston (54) is arranged in the cylinder chamber (55). The eccentric portion (46) fits inside the piston (54). When the drive shaft (45) is rotated, the piston (54) is rotated eccentrically about the shaft axis of the drive shaft (45) in the cylinder chamber (55). As a result, in the compression mechanism (50), the volume of a compression chamber formed in the cylinder chamber (55) varies, and thereby, a compression operation for compressing a refrigerant is performed.

The compression mechanism (50) is configured to discharge the compressed, high-pressure refrigerant whose temperature is high (for example, 120 °C) into the casing (30) through the discharge port (52a). That is, the compressor (20) of the third embodiment is a high-pressure dome type compressor having a configuration in which the interior space of the casing (30) is filled with the high-pressure refrigerant.

<Configuration or Power Converter>

The compressor (20) includes a power converter (60) for performing drive control of the drive motor (40). The power converter (60) is one of the power converters of the above-described embodiments.

As shown in FIG. 6, the power converter (60) is provided in an upper portion in the casing (30). The power converter (60) includes a substrate (61), and the switching device (130) and the snubber circuit (300) are provided on the substrate (61). In this embodiment, the switching device (130) and the snubber circuit (300) are arranged in a space between the compression mechanism (50) and the discharge pipe (35).

In the air conditioner (1) configured in the above-described manner, electromagnetic noise from the power electric converter can be insulated by the casing (30). Also, the size of the air conditioner (1) as a whole can be reduced.

The switching device (130) is arranged close to the snubber circuit (300), so that the interconnect inductance can be reduced, thus realizing high speed operation of the power converter.

When the compression mechanism (50) is in operation, the high-pressure refrigerant in the casing (30) cools down the snubber circuit (300) and the switching device (130) of the power converter. Therefore, in the power converter, the power converter (i.e., the air conditioner) can be efficiently operated. Moreover, heat of the switching devices (130) and the like can be collected to be used for heating.

«Variations of Third Embodiment»

In this variation, the switching device (130) and the snubber circuit (300) are supported by the insulators (42c), which serves as the insulation portions. Thus, the insulators (42c) can be used as a substrate of the switching device (130) and the snubber circuit (300). Heat generated from the switching device (130) and the snubber circuit (300) is transferred to the stator core portion (42a) via the insulators (42c), so that the heat is easily released to the high-pressure refrigerant flowing around the stator core portion (42a). Therefore, according to this variation, a greater cooling effect on the switching device (130) and the snubber circuit (300) can be achieved.

Moreover, the switching device (130) and the snubber circuit (300) are attached to the insulators (42c). Thus, the distance from the coil portions (42b) of the drive motor (40) to the inverter circuit (120) can be reduced. That is, in this variation, the interconnect length between the inverter circuit (120) and the coil portions (42b) can be reduced.

«Fourth Embodiment»

In a fourth embodiment, an example in which the snubber circuit (300) and the switching device (130) are provided in a single package (e.g., using a transfer mode technique) will be described. The influence of the interconnect inductance can be further reduced by incorporating the snubber circuit (300) and the switching device (130) in a single package.

In the following example, each of all of terminals of the snubber circuit (300) electrically coupled to the switching device (130) is directly connected to the switching device (130), an interconnect member directly connected to the switching device (130), or an interconnect member directly connected to the switching device (130) via a heat spreader. In this case, such interconnect members are a bonding wire, a lead frame, an interconnect pattern, a heat spreader, and the like. The terminals of the snubber circuit (300) correspond to, for example, a lead line of a capacitor, an external electrode and the like in the snubber circuit of FIG. 3A, and a lead line and an electrode of a capacitor and a resistor and the like of the snubber circuit which are electrically coupled to the switching element in the example snubber circuit of FIG. 3B.

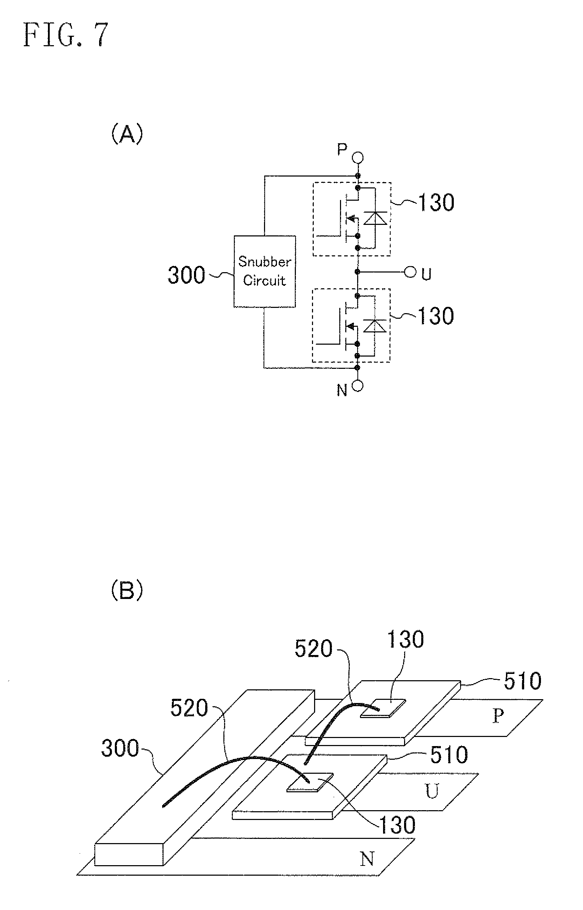

For example, as shown in FIG. 7A, when a snubber circuit (300) is provided for each phase (i.e., for each series circuit) in the inverter circuit (120), the inverter circuit (120) and the snubber circuit (300) are arranged, for example, in the manner shown in FIG. 7B. Note that terminals (external terminals) P, U and N of FIG. 7A correspond to interconnect patterns P, U and N of FIG. 7B, respectively. In this example, a SiC MOSFET is used as the switching device (130).

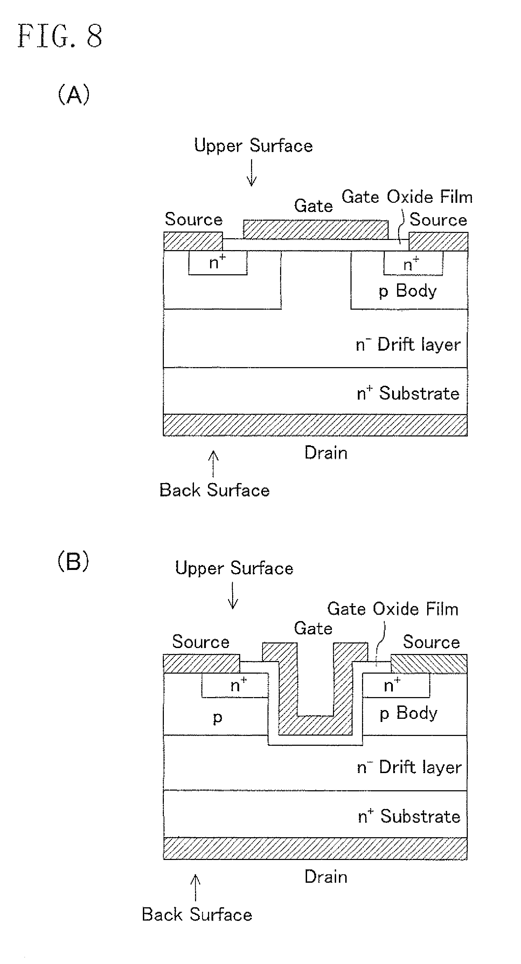

In each example of this embodiment, the SiC MOSFET has a vertical structure. Specifically, as shown in FIGS. 8A and 8B, an upper surface of a chip of the switching device serves as a source, and a back surface of the chip serves as a drain. FIG. 8A shows a DiMOSFET, and FIG. 8B shows a UMOSFET.

As shown in FIG. 7B, in this example, the snubber circuit (300) is directly connected to the interconnect patterns P and N. Each of the switching devices (130) is connected to an associated one of the interconnect patterns P and U via a heat spreader (510). One of the switching devices (130) above the interconnect pattern P is connected to an associated one of the heat spreaders (510) above the interconnect pattern U by an associated one of bonding wires (520), and the other one of the switching devices (130) above the interconnect pattern U is connected to the snubber circuit (300) by an associated one of the bonding wires (520).

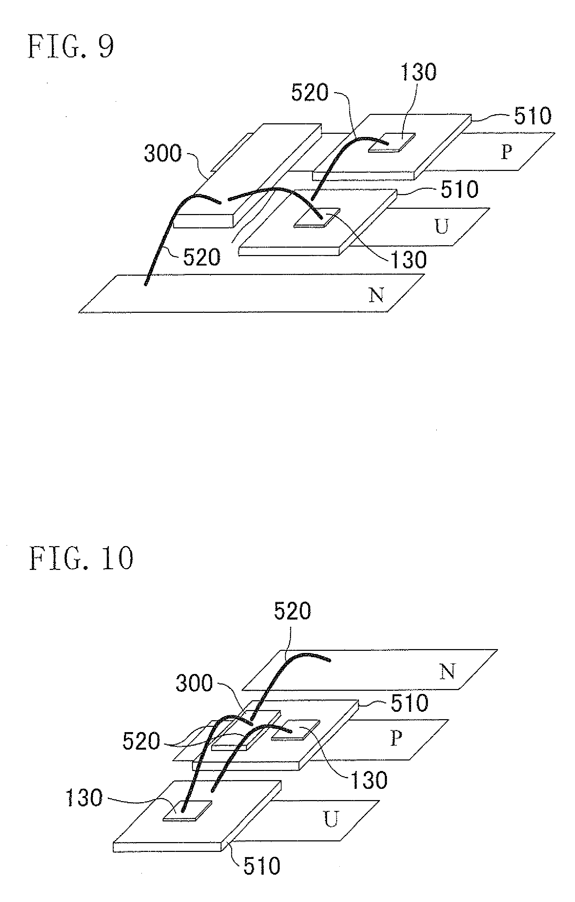

FIG. 9 also shows an example chip arrangement in which a snubber circuit (300) is provided for each phase (i.e., for each series circuit) in the inverter circuit (120) (see FIG. 7A). In this example, the snubber circuit (300) is directly connected to the interconnect pattern P, is connected to the interconnect pattern N by an associated one of the bonding wires (520), and further is connected to the switching device (130) above the interconnect pattern U by an associated one of the bonding wires (520). The switching device (130) above the interconnect pattern P is connected to the heat spreader (510) above the interconnect pattern U by an associated one of the bonding wires (520).

FIG. 10 also shows an example chip arrangement in which a snubber circuit (300) is provided for each phase (i.e., for each series circuit) in the inverter circuit (120). Also, in this example, each of the switching devices (130) is provided via an associated one of the heat spreaders (510). The snubber circuit (300) is arranged with the switching device (130) above the interconnect pattern P on the same heat spreader (510). In this example, the snubber circuit (300) is connected to the interconnect pattern N by an associated one of the bonding wires (520) and is connected to the switching device (130) above the interconnect pattern U by an associated one of the bonding wires (520), and the switching device (130) above the interconnect pattern P is connected to the heat spreader (510) above the interconnect pattern U by an associated one of the bonding wires (520).

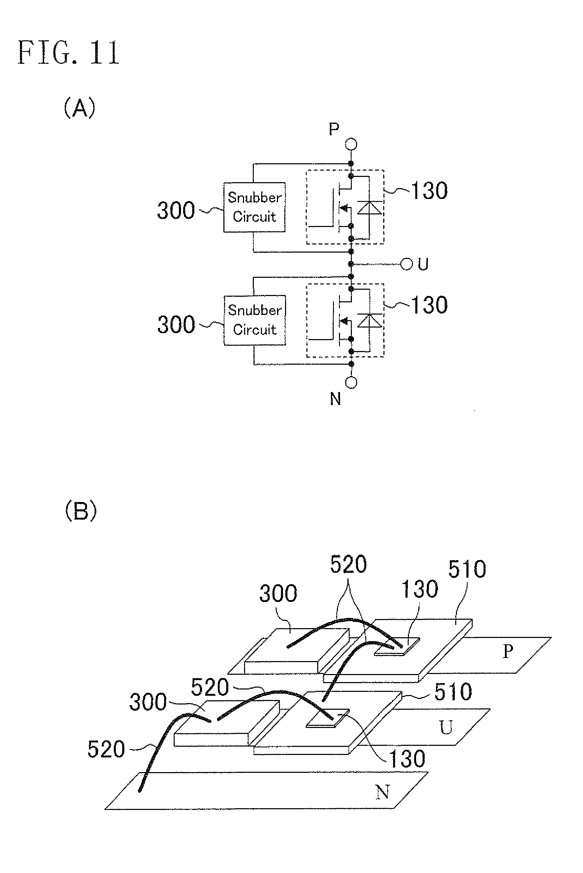

As shown in FIG. 11A, when a snubber circuit (300) is provided for each switching device (130), the inverter circuit (120) and the snubber circuit (300) are arranged, for example, in the manner shown in FIG. 11B. One of the snubber circuits (300) is directly connected to the interconnect pattern P, and the other one of the snubber circuits (300) is directly connected to the interconnect pattern U. Each of the switching devices (130) is connected to an associated one of the interconnect patterns P and U via an associated one of the heat spreaders (510), and also, is connected to an associated one of the snubber circuits (300) by an associated one of the bonding wires (520). The snubber circuit (300) above the interconnect pattern U is connected to the interconnected pattern N by an associated one of the bonding wires (520), and the switching device (130) above the interconnected pattern P is connected to the heat spreader (510) above the interconnected pattern U by an associated one of the bonding wires (520).

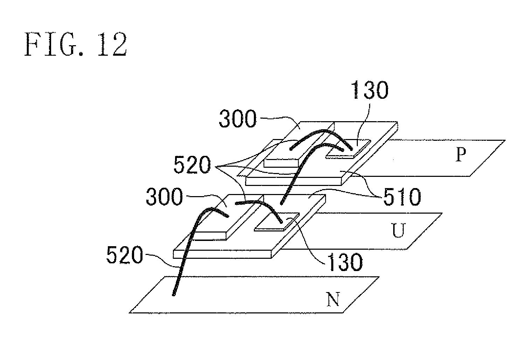

FIG. 12 also shows an example in which a snubber circuit (300) is provided for each switching device (130). In this example, each of the snubber circuits (300) and an associated one of the switching devices (130) are arranged on a common heat spreader (510). Each of the switching devices (130) is connected to an associated one of the snubber circuits (300) by an associated one of the bonding wires (520). Also, the snubber circuit (300) above the interconnect pattern U is connected to the interconnected pattern N by an associated one of the bonding wires (520), and the switching device (130) above the interconnect pattern P is connected to the heat spreader (510) above the interconnect pattern U by an associated one of the bonding wires (520).

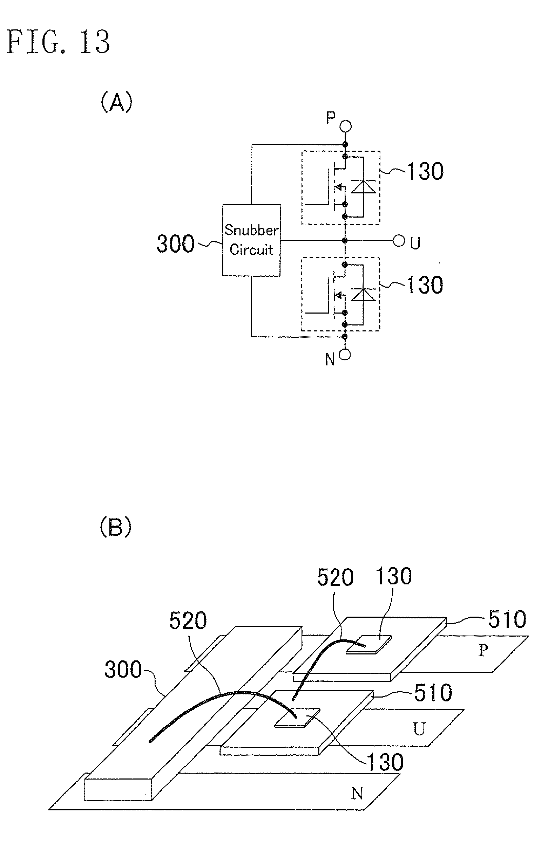

A circuit shown in FIG. 13A is an example in which a snubber circuit (300) is provided for each switching circuit (130). In this case, the inverter circuit (120) and the snubber circuit (300) are arranged, for example, in the manner shown in FIG. 13B. In this example, the snubber circuit (300) is directly connected to the interconnect patterns P, U and N. Each of the switching devices (130) is connected to an associated one of the interconnect patterns P and U via an associated one of the heat spreaders (510). The switching device (130) above the interconnect pattern P is connected to the heat spreader (510) above the interconnect pattern U by an associated one of the bonding wires (520), and the switching device (130) above the interconnect pattern U is connected to the snubber circuit (300) by an associated one of the bonding wires (520).

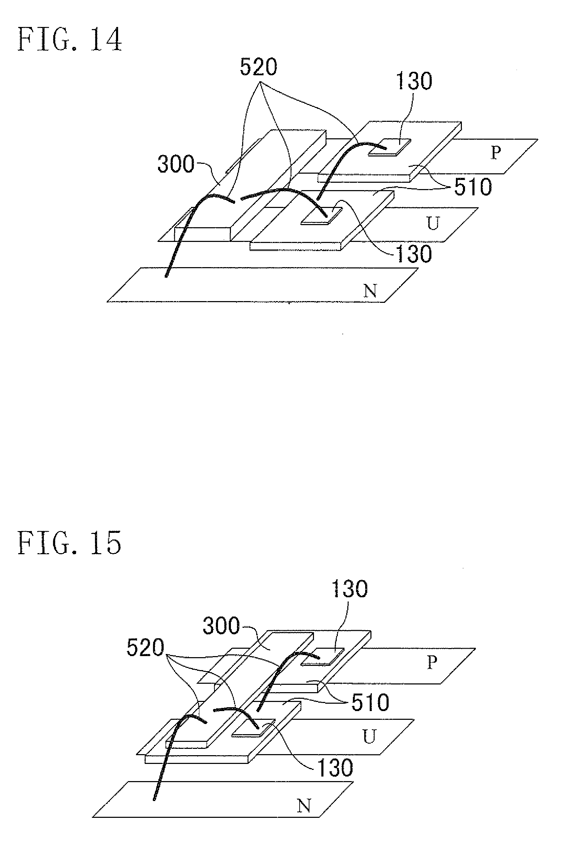

FIG. 14 also shows an example in which a snubber circuit (300) is provided for each switching circuit (130). Also, in this example, each of the switching devices (130) is connected to an associated one of the interconnect patterns P and U via an associated one of the heat spreaders (510). The switching device (130) above the interconnect pattern P is connected to the heat spreader (510) above the interconnect pattern U by an associated one of the bonding wires (520). The snubber circuit (300) is directly connected to the interconnect patterns P and U, is connected to the interconnect pattern N by an associated one of the bonding wires (520), and is connected to the switching device (130) above the interconnected pattern U by an associated one of the bonding wires (520).

FIG. 15 also shows an example in which a snubber circuit (300) is provided for each switching circuit (130). Also, in this example, each of the switching devices (130) is connected to an associated one of the interconnect patterns P and U via an associated one of the heat spreaders (510). The switching device (130) above the interconnect pattern P is connected to the heat spreader (510) above the interconnect pattern U by an associated one of the bonding wires (520). The snubber circuit (300) of this example is connected to the interconnect patterns P and U via the heat spreaders (510) for the switching devices (130). That is, the snubber circuit (300) and the switching devices (130) share the heat spreaders (510). The snubber circuit (300) is connected to the interconnect pattern N by an associated one of the bonding wires (520).

To arrange the snubber circuit (300) on the interconnect patterns and the heat spreaders in the above-described manner and thus allow wire bonding of the snubber circuit (300) directly to the external electrodes (P, U and N), for example, a chip structure shown in FIG.

16 can be used. This example includes the snubber circuit of FIG. 3B. In this example, a resistive material (602a) provided in contact with an external electrode (601) serves as a resistor (602). A dielectric material (603b) is provided between an internal electrode (603a) and an external electrode (604) each being formed to have a comb shape to serve as a capacitor (603) between the internal electrode (603a) and the external electrode (604). The resistor (602) (resistive material (602a)) and the capacitor (603) are surrounded by a protective film (605) from both sides. In this snubber circuit (300), the external electrode (601) and the external electrode (604) serve as terminals of the snubber circuit connected to the switching devices (130).

By utilizing the above-described configurations, a switching device and a snubber circuit can be arranged to be close to one another, so that the interconnect inductance can be reduced to a minimum level.

INDUSTRIAL APPLICABILITY

The present invention is useful as a power converter including a switching device.

**Claims**

1. A power converter for converting AC power supplied from an AC power source or DC power supplied from a DC power source to DC power or AC power having predetermined voltage and frequency, the power converter comprising:

   at least one switching device (130) configured to be operable at high temperature; and
   at least one snubber circuit (300) configured to be operable at high temperature and having a capacitor (301) configured to be operable at high temperature.

2. The power converter of claim 1, wherein an operating temperature of the at least one switching device (130) is 150°C or more.

3. The power converter of claim 1, wherein the at least one switching device (130) is a semiconductor device using wide band gap semiconductor as a primary material.

4. The power converter of claim 1, wherein an allowable temperature of the at least one snubber circuit (300) is 150°C or more.

5. The power converter of claim 4, wherein the capacitor (301) of the at least one snubber circuit (300) is a ceramic capacitor.

6. The power converter of claim 4, wherein

the capacitor (301) of the at least one snubber circuit (300) is a film capacitor using a high heat resistance material as a dielectric material.

7. The power converter of claim 1, wherein the at least one snubber circuit (300) includes a diode using wide band gap semiconductor as a primary material.

8. The power converter of claim 3, wherein the wide band gap semiconductor is one of silicon carbide, gallium nitride and diamond.

9. The power converter of claim 1, wherein multiple ones of the at least one switching device (130) are connected in series to serve as a series circuit (170),
multiple ones of the series circuit (170) are arranged in parallel, and
multiple ones of the at least one snubber circuit (300) are arranged so that each of the snubber circuits (300) corresponds to an associated one of the series circuits (170).

10. The power converter of claim 1, wherein the at least one snubber circuit (300) is arranged so that each of the at least one snubber circuit (300) corresponds to an associated one of the at least one switching device (130).

11. The power converter of claim 1, wherein the at least one switching device (130) and the at least one snubber circuit (300) are arranged in the same package.

12. The power converter of claim 1, wherein the at least one switching device (130) and the at least one snubber circuit (300) are arranged on the same substrate.

13. The power converter of claim 11, wherein the at least one switching device (130) is directly connected to terminals of the at least one snubber circuit (300).

14. The power converter of claim 11, wherein each of all of terminals of the at least one snubber circuit (300) electrically coupled to the at least one switching device (130) is directly connected to the at least one switching device (130), an interconnect member directly connected to the at least one switching device (130), or an interconnect member directly connected to the at least one switching device (130) via a heat spreader (510).

15. The power converter of claim 1, wherein the power converter drives a drive motor (40) provided in a compressor (20) including a compression mechanism (50) for compressing a refrigerant, the drive motor (40) for driving the compression mechanism (50), and a casing (30) in which the compression mechanism (50) and the drive motor (40) are provided and which is filled with the refrigerant.

16. The power converter of claim 15, wherein the compression mechanism (50) is configured to discharge a high-pressure refrigerant into the casing (30), and a discharge pipe (35) for causing the high-pressure refrigerant in the casing (30) to flow to the outside of the casing (30) is connected to the casing (30).

17. The power converter of claim 15, wherein the at least one snubber circuit (300) and the at least one switching device (130) are arranged in the casing (30).

18. The power converter of claim 15, wherein the drive motor (40) includes a stator core portion (42a) fixed to an inner wall of the casing (30) and insulating portions (42c) formed on end surfaces of the stator core portion (42a) in a direction along a shaft, and the at least one switching device (130) and the at least one snubber circuit (300) are supported by the insulating portions (42c).

19. The power converter of claim 15, wherein the at least one switching device (130) and the at least one snubber circuit (300) are arranged between the compression mechanism (50) and the discharge pipe (35).

20. The power converter of claim 15, wherein the compressor (20) is connected to a heat pump circuit including a refrigerant circuit (10) for performing refrigeration cycle by a refrigerant circulating.

21. A power converter for converting AC power supplied from an AC power source or DC power supplied from a DC power source to DC power or AC power having predetermined voltage and frequency, the power converter comprising:

> at least one switching device (130); and
> at least one snubber circuit (300) including a capacitor (341);
> wherein
> each of all of terminals of the at least one snubber circuit (300) electrically coupled to the at least one switching device (130) is directly connected to the at least one switching device (130), an interconnect member directly connected to the at least one switching device (130), or an interconnect member directly connected to the at least one switching device (130) via a heat spreader (510).

22. The power converter of claim 7, wherein the wide band gap semiconductor is one of silicon carbide, gallium nitride and diamond.

23. The power converter of claim 12, wherein the at least one switching device (130) is directly connected to terminals of the at least one snubber circuit (300).

24. The power converter of claim 13, each of all of the terminals of the at least one snubber circuit (300) electrically coupled to the at least one switching device (130) is directly connected to the at least one switching device (130), an interconnect member directly connected to the at least one switching device (130), or an interconnect member directly connected to the at least one switching device (130) via a heat spreader (510).

FIG. 1

FIG. 2

Interconnect
Length

300 — | Snubber Circuit | ←→ | Switching Device | — 130

FIG. 3

(A)

301

300

(B)

301

300

(C)

301

300

(D)

301

300

301

(E)

301

300

301

(F)

301

300

301

FIG. 4

EP 2 259 419 A1

FIG. 5

FIG. 6

EP 2 259 419 A1

17

# FIG. 7

(A)

(B)

# FIG. 8

## (A)

Upper Surface ↓

Source  Gate  Gate Oxide Film  Source

$n^+$  $n^+$

p Body

$n^-$ Drift layer

$n^+$ Substrate

Drain

↑ Back Surface

## (B)

Upper Surface ↓

Gate Oxide Film

Source  Gate  Source

$n^+$  $n^+$

p  p Body

$n^-$ Drift layer

$n^+$ Substrate

Drain

↑ Back Surface

FIG. 9

FIG. 10

FIG. 11

(A)

(B)

FIG. 12

FIG. 13

(A)

300 — Snubber Circuit

130

130

(B)

FIG. 14

FIG. 15

FIG. 16

## INTERNATIONAL SEARCH REPORT

| | International application No. |
|---|---|
| | PCT/JP2009/001068 |

**A. CLASSIFICATION OF SUBJECT MATTER**
*H02M7/48(2007.01)i*

According to International Patent Classification (IPC) or to both national classification and IPC

**B. FIELDS SEARCHED**

Minimum documentation searched (classification system followed by classification symbols)
H02M7/48

Documentation searched other than minimum documentation to the extent that such documents are included in the fields searched
Jitsuyo Shinan Koho        1922-1996   Jitsuyo Shinan Toroku Koho   1996-2009
Kokai Jitsuyo Shinan Koho   1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2007-194006 A  (Hitachi Appliances, Inc.),<br>02 August, 2007 (02.08.07),<br>Par. Nos. [0099] to [0108]; Figs. 1 to 13<br>(Family: none) | 1-17,20-24<br>18,19 |
| Y<br>A | JP 2007-135252 A  (Hitachi, Ltd.),<br>31 May, 2007 (31.05.07),<br>Par. Nos. [0026] to [0029]; Figs. 6 to 7<br>& US 2007/0103951 A1 | 1-17,20-24<br>18,19 |
| Y | WO 2006/003936 A1  (The Kansai Electric Power<br>Co., Inc.),<br>12 January, 2006 (12.01.06),<br>Par. No. [0026]<br>& US 2008/0043500 A1    & EP 1768244 A1 | 2 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>30 March, 2009 (30.03.09) | Date of mailing of the international search report<br>07 April, 2009 (07.04.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/001068

C (Continuation). DOCUMENTS CONSIDERED TO BE RELEVANT

| Category* | Citation of document, with indication, where appropriate, of the relevant passages | Relevant to claim No. |
|---|---|---|
| Y | JP 11-233364 A (Murata Mfg. Co., Ltd.), 27 August, 1999 (27.08.99), Par. Nos. [0022] to [0034] (Family: none) | 4-6 |
| Y | JP 7-201647 A (Matsushita Electric Industrial Co., Ltd.), 04 August, 1995 (04.08.95), Par. No. [0026] (Family: none) | 6 |
| Y | JP 2007-306692 A (Toshiba Corp.), 22 November, 2007 (22.11.07), Par. Nos. [0032] to [0033]; Fig. 5 (Family: none) | 9 |
| Y | JP 2002-135973 A (Toshiba Corp.), 10 May, 2002 (10.05.02), Par. No. [0004] (Family: none) | 11,13,14,24 |
| Y | JP 2001-359280 A (Origin Electric Co., Ltd.), 26 December, 2001 (26.12.01), Par. Nos. [0018] to [0019]; Fig. 4 (Family: none) | 12,23 |
| Y A | JP 2007-309110 A (Calsonic Kansei Corp.), 29 November, 2007 (29.11.07), Par. Nos. [0066] to [0074]; Fig. 4 & WO 2007/132885 A1 | 15-17,20 18,19 |

Form PCT/ISA/210 (continuation of second sheet) (April 2007)

**EP 2 259 419 A1**

## REFERENCES CITED IN THE DESCRIPTION

**Patent documents cited in the description**

- JP 2000224867 A